# EUROPEAN PATENT APPLICATION

(11) **EP 4 814 961 A1**
(43) Date of publication of application: **30.09.2026**
(21) Application number: 25223663.3
(22) Date of filing: 16.12.2025
(51) Int. Cl.: G11C 8/08, G11C 11/408, G11C 16/08

(54) **APPARATUS AND METHOD OF TRANSMITTING PASS VOLTAGE IN MEMORY DEVICE**

(30) Priority: 24.03.2025 KR 20250037311
(71) Applicant: SK hynix Inc., Bubal-eub Icheon-si Gyeonggi-do 17336 (KR)
(72) Inventor: JO, Eun Woo, 17336 Icheon-si, Gyeonggi-do (KR)
(74) Representative: Isarpatent

(57) **Abstract**

A memory device includes a memory region comprising a plurality of memory cells connected to word lines and bit lines, a voltage generation unit configured to generate a pass voltage and an equalizing voltage, a first transfer unit configured to transfer the pass or equalizing voltage between the voltage generation unit and the word lines via a first path, a second transfer unit configured to transfer the pass voltage between the voltage generation unit and the word lines via a second path physically separated from the first path, and an operation control unit configured to enable the first transfer unit and the second transfer unit such that the pass voltage is transferred via the first path and the second path during a pass voltage rise interval and to enable the first transfer unit such that the equalizing voltage is transferred through the first path during an equalizing interval.

## Description

### BACKGROUND

### 1. Field

The present disclosure relates to a semiconductor device, including but not limited to an apparatus and method of transmitting a pass voltage in a nonvolatile memory device.

### 2. Related Art

Memory systems include storage devices embodied using semiconductors such as silicon (Si), germanium (Ge), gallium arsenide (GaAs), indium phosphide (InP), or the like. Memory devices are classified as volatile memory devices or nonvolatile memory devices. Volatile memory devices are memory devices in which stored data is lost when the power supply to the device is interrupted. Examples of volatile memory devices include static RAM (SRAM), dynamic RAM (DRAM), synchronous DRAM (SDRAM), and so forth. Nonvolatile memory devices are memory devices in which stored data is retained when the power supply to the device is interrupted. Examples of nonvolatile memory devices include a read only memory (ROM), a programmable ROM (PROM), an electrically programmable ROM (EPROM), an electrically erasable programmable ROM (EEPROM), a flash memory, a phase-change random access memory (PRAM), a magnetic RAM (MRAM), a resistive RAM (RRAM), a ferroelectric RAM (FRAM), and so forth. Flash memories are classified as NOR-type memory or NAND-type memory.

A nonvolatile memory device includes a plurality of memory cells connected between a plurality of word lines and a plurality of bit lines. Each of the plurality of memory cells included in the nonvolatile memory device is an element capable of an electrical program/erase operation and program and erase operations may be performed by changing the threshold voltage of each memory cell as electrons are moved by a strong electric field applied to a thin oxide film. Each of the plurality of memory cells included in the nonvolatile memory device performs a read operation by identifying the level of the threshold voltage of each memory cell.

After the start of a program operation or a read operation for the plurality of memory cells included in the nonvolatile memory device, a program or read voltage is applied to a selected word line, among the plurality of word lines, and a pass voltage is applied to an unselected word line, among the plurality of word lines. In this example, the pass voltage is a sufficiently high voltage level at which all of the memory cells of the unselected word line may be turned on such that the memory cells of the unselected word line that is not selected as a program or read target do not hinder the program operation or read operation.

### SUMMARY

In an embodiment, a memory device may include: a memory region comprising a plurality of memory cells connected to a plurality of word lines and a plurality of bit lines; a voltage generation unit configured to generate a pass voltage and an equalizing voltage; a first transfer unit configured to transfer the pass voltage or the equalizing voltage between the voltage generation unit and the plurality of word lines via a first path; a second transfer unit configured to transfer the pass voltage between the voltage generation unit and the plurality of word lines via a second path physically separated from the first path; and an operation control unit configured to enable the first transfer unit and the second transfer unit such that the pass voltage is transferred via the first path and the second path during a pass voltage rise interval and to enable the first transfer unit such that the equalizing voltage is transferred via the first path during an equalizing interval after a start of a read operation or a program operation.

In an embodiment, a method of operating a memory device comprising a memory region comprising a plurality of memory cells connected to a plurality of word lines and a plurality of bit lines, a voltage generation unit configured to generate a pass voltage and an equalizing voltage, and a first path physically separated from a second path between the voltage generation unit and the plurality of word lines, the method may include: a first transfer process including transferring the pass voltage generated by the voltage generation unit to at least one word line, among the plurality of word lines, via the first path and the second path during a pass voltage rise interval after a start of a read operation or a program operation; and a second transfer process including transferring the equalizing voltage generated by the voltage generation unit to the plurality of word lines via the first path during an equalizing interval after the start of the read operation or the program operation.

In an embodiment, a method may include generating, by a voltage generation unit, a pass voltage and an equalizing voltage in a memory device comprising a plurality of memory cells connected to a plurality of word lines; transferring the pass voltage to at least one word line, among the plurality of word lines, via a first path and a second path, which are physically separated from each other, during a pass voltage rise interval after a start of a read operation or a program operation; and transferring the equalizing voltage to the plurality of word lines via the first path during an equalizing interval after the start of the read operation or the program operation.

### BRIEF DESCRIPTION OF THE DRAWINGS

FIG. 1 illustrates a memory device in which a pass voltage is transferred according to an embodiment of the present disclosure.
FIG. 2 illustrates a voltage generation unit according to an embodiment of the present disclosure.
FIG. 3A to FIG. 3C illustrate a memory device during transfer of a pass voltage and an equalizing voltage according to an embodiment of the present disclosure.
FIG. 4A and FIG. 4B are timing diagrams during change of the voltage levels of word lines according to an embodiment of the present disclosure.
FIG. 5 illustrates a memory device according to an embodiment of the present disclosure.

### DETAILED DESCRIPTION

Embodiments of the present disclosure are described in detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

Terms such as "first" and "second" are used to distinguish between various elements and do not imply size, order, priority, quantity, importance, time, distance, or logic of the elements. For example, a first element may be referred to as a second element in one example, and the second element may be referred to as a first element in another example.

When one element is identified as "connected" to another element, the elements may be connected directly or through at least one intervening element between the elements. When two elements are identified as "directly connected," one element is directly connected to the other element without an intervening element between the two elements.

A "pass voltage rise interval" includes the time interval from the time for the pass voltage to rise from ground voltage VSS to the level of the pass voltage at which time the pass voltage is applied to an unselected word line. Reducing the length of the pass voltage rise interval reduces the time to perform a program operation or a read operation.

An embodiment includes a memory device capable of reducing a pass voltage rise interval after the start of a read or program operation and a method of operation of the memory device. During the pass voltage rise interval, the level of the pass voltage can be rapidly raised to a target level, thus, the length of the pass voltage rise interval can be reduced.

According to the present description, a memory device includes a voltage generation circuit and physically separated transfer paths between the voltage generation circuit and a plurality of word lines. The equalizing voltage may be transferred through a first transfer path during an equalizing interval. The pass voltage may be transferred through the transfer paths during the pass voltage rise interval that does not overlap with the equalizing interval. During the equalizing interval or the pass voltage rise interval, the equalizing voltage or the pass voltage may be transferred through a first transfer path.

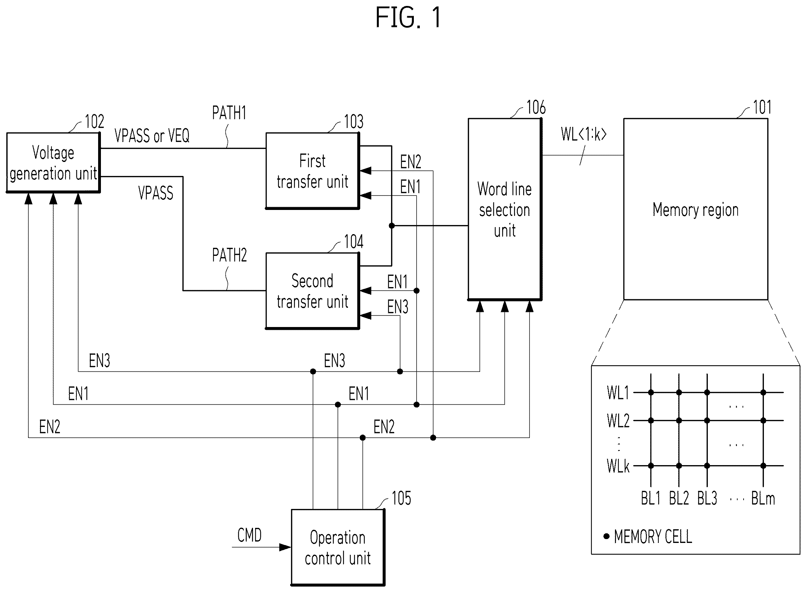

The block diagrams of FIG. 1, FIG. 2, FIG. 3A through FIG. 3C, and FIG. 5 may be implemented with circuitry or logic gates in accordance with the descriptions associated with FIG. 1, FIG. 2, FIG. 3A through FIG. 3C, and FIG. 5. "Circuitry" or "logic gates" include, but are not limited to, (a) hardware-only circuit implementations, such as implementations in analog and/or digital circuitry, and (b) combinations of circuitry, software, and/or firmware, including one or more processors configured to execute instructions, such as in the form of software or firmware, stored in one or more non-transitory computer-readable media, such as memory devices, to cause an electronic device to perform one or more functions.

FIG. 1 illustrates a memory device in which a pass voltage is transferred according to an embodiment of the present disclosure.

Referring to FIG. 1, the memory device according to an embodiment of the present disclosure includes a memory region 101, a voltage generation unit 102, a first transfer unit 103, a second transfer unit 104, an operation control unit 105, and a word line selection unit 106.

In this example, the memory region 101 includes a plurality of memory cells MEMORY CELL that are connected to a plurality of word lines WL<1:k> and a plurality of bit lines BL<1:m>. For example, each of the plurality of memory cells includes a single level cell SLC that stores one data bit, a multi-level cell MLC that stores two data bits, a triple level cell TLC that stores three data bits, or a quad level cell QLC that stores four data bits.

The word line selection unit 106 selects at least one word line among the plurality of word lines WL<1:k> included in the memory region 101.

According to an embodiment, after the start of a program operation or a read operation, the word line selection unit 106 selects one word line, a "selected word line" among the plurality of word lines WL<1:k>. After the start of the program operation or the read operation, the word line selection unit 106 selects the word lines, "unselected word lines," among the plurality of word lines WL<1:k> except for the selected word line. The word line selection unit 106 may select each of the plurality of word lines WL<1:k>.

The voltage generation unit 102 generates a pass voltage VPASS and an equalizing voltage VEQ.

A program operation for a memory device is described.

Each of the plurality of word lines WL<1:k> is equalized at the level of the equalizing voltage VEQ by performing an initial equalizing operation on each of the plurality of word lines WL<1:k>. For example, during the initial equalizing operation, the equalizing voltage VEQ is the level of a ground voltage VSS. During the initial equalizing operation interval, each of the plurality of word lines WL<1:k> is equalized at the level of the ground voltage in this example.

A voltage at each the plurality of word lines WL<1:k> is raised to the level of the pass voltage VPASS by performing a pass voltage rise operation on each of the plurality of word lines WL<1:k>.

An unselected word line, among the plurality of word lines WL<1:k>, is maintained at the level of the pass voltage VPASS by performing a pass voltage maintenance operation on the unselected word line. When the pass voltage maintenance operation is performed on the unselected word line as described, the level of the threshold voltage of a memory cell connected to a selected word line is changed by performing a program voltage application operation on the selected word line.

Each of the plurality of word lines WL<1:k> is equalized at the level of the equalizing voltage VEQ by performing a post equalizing operation on each of the plurality of word lines WL<1:k>. In this example, during the post equalizing operation, the equalizing voltage VEQ is higher than the level of the ground voltage VSS and lower than the level of a source voltage VDD. During the post equalizing operation interval, each of the plurality of word lines WL<1:k> is equalized at a voltage level that is higher than the voltage level at ground voltage VSS and lower than the voltage level at the source voltage VDD.

A read operation for a memory device is described.

Each of the plurality of word lines WL<1:k> is equalized at the level of the equalizing voltage VEQ by performing an initial equalizing operation on each of the plurality of word lines WL<1:k>. In this example, during the initial equalizing operation, the equalizing voltage VEQ is at the level of the ground voltage VSS. During the initial equalizing operation interval, each of the plurality of word lines WL<1:k> is be equalized at the level of the ground voltage VSS.

Each unselected word line, among the plurality of word lines WL<1:k>, is raised to the level of the pass voltage VPASS by performing a pass voltage rise operation on each of the unselected word lines.

An unselected word line, among the plurality of word lines WL<1:k>, is maintained at the level of the pass voltage VPASS by performing a pass voltage maintenance operation on the unselected word line.

The level of the threshold voltage of a memory cell that is connected to a selected word line is sensed by performing a read voltage application operation on the selected word line during the interval in which the pass voltage rise operation and the pass voltage maintenance operation are performed on the unselected word line.

Each of the plurality of word lines WL<1:k> is equalized at the level of the equalizing voltage VEQ by performing a post equalizing operation on each of the plurality of word lines WL<1:k>. In this example, during the post equalizing operation, the equalizing voltage VEQ is at a voltage level that is higher than the level of the ground voltage VSS and lower than the level of the source voltage VDD. During the interval of the post equalizing operation, each of the plurality of word lines WL<1:k> is equalized at a voltage level that is higher than the level of the ground voltage VSS and lower than the level of the source voltage VDD.

The initial equalizing interval and the post equalizing interval are different in the level of the equalizing voltage VEQ during each of the initial equalizing interval and the post equalizing interval and are the same in that each of the plurality of word lines WL<1:k> are equalized at the level of the equalizing voltage VEQ. The phrase "equalizing operation" without a qualifier "initial" or "post" collectively refers to both the initial equalizing interval and the post equalizing interval.

Referring to FIG. 1, the first transfer unit 103 transfers the pass voltage VPASS or the equalizing voltage VEQ between the voltage generation unit 102 and the word line selection unit 106 via a first path PATH1. The first transfer unit 103 in an enabled state transfers the pass voltage VPASS or the equalizing voltage VEQ generated by the voltage generation unit 102 through the first path PATH1 to at least one word line selected by the word line selection unit 106, among the plurality of word lines WL<1:k>. The first transfer unit 103 in a disabled state does not transfer electrical signals from the first path PATH1, for example, by creating an open circuit with the first path PATH1.

The second transfer unit 104 transfers the pass voltage VPASS between the voltage generation unit 102 and the word line selection unit 106 via a second path PATH2. The second transfer unit 104 in the enabled state transfers the pass voltage VPASS generated by the voltage generation unit 102 via the second path PATH2 to at least one word line selected by the word line selection unit 106, among the plurality of word lines WL<1:k>. The second transfer unit 104 in the disabled state does not transfer electrical signals from the second path PATH2, for example, by creating an open circuit with the second path PATH2.

When transferring the pass voltage VPASS generated by the voltage generation unit 102 to at least one word line selected by the word line selection unit 106 during a pass voltage rise interval after the start of a read or program operation, the operation control unit 105 enables both the first transfer unit 103 and the second transfer unit 104 to control both the first path PATH1 and the second path PATH2.

When transferring the equalizing voltage VEQ generated by the voltage generation unit 102 to at least one word line selected by the word line selection unit 106, during an equalizing interval after the start of a read or program operation, the operation control unit 105 enables the first transfer unit 103 to control the first path PATH1. The operation control unit 105 disables the second transfer unit 104 to control the second path PATH2 to be open circuit during the equalizing interval.

When transferring the pass voltage VPASS generated by the voltage generation unit 102 to at least one word line selected by the word line selection unit 106 during a pass voltage keeping interval after the start of a read or program operation, the operation control unit 105 enables the second transfer unit 104 to control the second path PATH2. The operation control unit 105 disables the first transfer unit 103 to control the first path PATH1 to be open circuit during the pass voltage keeping interval.

The word line selection unit 106 selects an unselected word line as an operation target during a pass voltage rise interval. The word line selection unit 106 drives the unselected word line to the pass voltage VPASS transferred via the first transfer unit 103 and the second transfer unit 104 during the pass voltage rise interval.

The word line selection unit 106 selects an unselected word line as an operation target during a pass voltage keeping interval. The word line selection unit 106 drives the unselected word line to the pass voltage VPASS transferred via the second transfer unit 104 during the pass voltage keeping interval.

The word line selection unit 106 selects each of the plurality of word lines WL<1:k> as an operation target during an equalizing interval. The word line selection unit 106 drives each of the plurality of word lines WL<1:k> to the equalizing voltage VEQ transferred via the first transfer unit 103 during the equalizing interval.

For example, the operation control unit 105 generates a first control signal EN1 that is activated during a pass voltage rise interval and that is deactivated during a pass voltage keeping interval and an equalizing interval. The operation control unit 105 generates a second control signal EN2 that is activated during an equalizing interval and that is deactivated during a pass voltage rise interval and a pass voltage keeping interval. The operation control unit 105 generates a third control signal EN3 that is activated during a pass voltage keeping interval and that is deactivated during a pass voltage rise interval and an equalizing interval.

The first transfer unit 103 is enabled during the activated interval of the first control signal EN1 and the second control signal EN2. The first transfer unit 103 is enabled during a pass voltage rise interval or an equalizing interval corresponding to the activated interval of the first control signal EN1 or the second control signal EN2 and is disabled during a pass voltage keeping interval corresponding to the deactivated interval of the first control signal EN1 and the second control signal EN2.

The second transfer unit 104 is enabled during the activated interval of the first control signal EN1 and the third control signal EN3. The second transfer unit 104 is enabled during a pass voltage rise interval or a pass voltage keeping interval corresponding to the activated interval of the first control signal EN1 or the third control signal EN3 and is disabled during an equalizing interval corresponding to the deactivated interval of the first control signal EN1 or the third control signal EN3.

The voltage generation unit 102 generates the pass voltage VPASS during a pass voltage rise interval or a pass voltage keeping interval corresponding to the activated interval of the first control signal EN1 or the third control signal EN3 and generates the equalizing voltage VEQ during an equalizing interval corresponding to the activated interval of the second control signal EN2. The voltage generation unit 102 does not generate the pass voltage VPASS during an equalizing interval corresponding to the deactivated interval of the first control signal EN1 or the third control signal EN3 in an embodiment. The voltage generation unit 102 does not generate the equalizing voltage VEQ during a pass voltage rise interval or a pass voltage keeping interval corresponding to the deactivated interval of the second control signal EN2.

The word line selection unit 106 selects an unselected word line as an operation target during a pass voltage rise interval corresponding to the activated interval of the first control signal EN1. The word line selection unit 106 drives the unselected word line to the pass voltage VPASS that is transferred through the first transfer unit 103 and the second transfer unit 104 during the pass voltage rise interval corresponding to the activated interval of the first control signal EN1 in an embodiment.

The word line selection unit 106 selects an unselected word line as an operation target during a pass voltage keeping interval corresponding to the activated interval of the third control signal EN3. The word line selection unit 106 drives the unselected word line to the pass voltage VPASS that is transferred through the second transfer unit 104 during the pass voltage keeping interval corresponding to the activated interval of the third control signal EN3 in an embodiment.

The word line selection unit 106 selects each of the plurality of word lines WL<1:k> as an operation target during an equalizing interval corresponding to the activated interval of the second control signal EN2. The word line selection unit 106 drives each of the plurality of word lines WL<1:k> to the equalizing voltage VEQ that is transferred through the first transfer unit 103 during the equalizing interval corresponding to the activated interval of the second control signal EN2 in an embodiment.

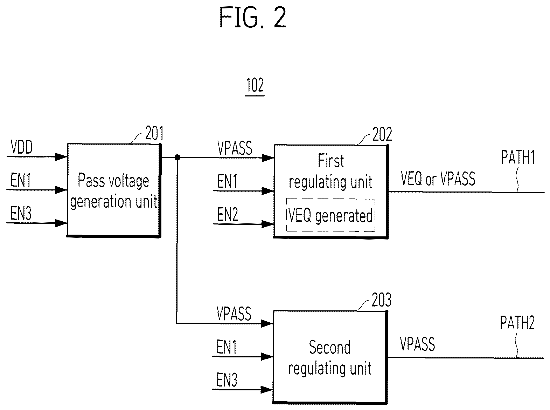

FIG. 2 illustrates a voltage generation unit, for example, as illustrated in FIG. 1.

Referring to FIG. 2, the voltage generation unit 102 includes a pass voltage generation unit 201, a first regulating unit 202, and a second regulating unit 203.

In this example, the pass voltage generation unit 201 generates the pass voltage VPASS. In this example, the pass voltage generation unit 201 generates the pass voltage VPASS using a charge pumping method because the level of the pass voltage VPASS is higher than the level of the source voltage VDD.

The pass voltage generation unit 201 generates the pass voltage VPASS by charge pumping the source voltage VDD during a pass voltage rise interval and a pass voltage keeping interval. The pass voltage generation unit 201 generates the pass voltage VPASS in response to generation of the first control signal EN1 by the operation control unit 105 that maintains the activated state during the pass voltage rise interval. The pass voltage generation unit 201 generate the pass voltage VPASS in response to generation of the third control signal EN3 by the operation control unit 105 that maintains the activated state during the pass voltage keeping interval.

The first regulating unit 202 stabilizes the first path PATH1 using the pass voltage VPASS transferred by the pass voltage generation unit 201 during a pass voltage rise interval. The first regulating unit 202 internally generates the equalizing voltage VEQ within the first regulating unit 202 during an equalizing interval and stabilizes the first path PATH1 using the generated equalizing voltage VEQ. The first regulating unit 202 stabilizes the first path PATH1 using the pass voltage VPASS generated by the pass voltage generation unit 201 in response to generation of the first control signal EN1 by the operation control unit 105 that maintains the activated state during the pass voltage rise interval. The first regulating unit 202 stabilizes the first path PATH1 using the generated equalizing voltage VEQ after internally generating the equalizing voltage VEQ within the first regulating unit 202 in response to generation of the second control signal EN2 by the operation control unit 105 that maintains the activated state during the equalizing interval.

In this example, to stabilizing the first path PATH1 includes the first regulating unit 202 maintaining the voltage level of the first path PATH1 at the level of the pass voltage VPASS or the equalizing voltage VEQ by adjusting the voltage level of the first path PATH1 when the voltage level of the first path PATH1 is different from the level of the pass voltage VPASS or the equalizing voltage VEQ. For example, when the voltage level of the first path PATH1 is lower than the level of the pass voltage VPASS, the first regulating unit 202 raises the voltage level of the first path PATH1 to the level of the pass voltage VPASS and maintains the voltage level of the first path PATH1 at the level of the pass voltage VPASS. For example, when the voltage level of the first path PATH1 is higher than the level of the equalizing voltage VEQ, the first regulating unit 202 lowers the voltage level of the first path PATH1 to the level of the equalizing voltage VEQ and maintains the voltage level of the first path PATH1 at the level of the equalizing voltage VEQ.

The second regulating unit 203 stabilizes the second path PATH2 using the pass voltage VPASS transferred by the pass voltage generation unit 201 during the pass voltage rise interval and the pass voltage keeping interval. The second regulating unit 203 stabilizes the second path PATH2 using the pass voltage VPASS generated by the pass voltage generation unit 201 in response to generation of the first control signal EN1 by the operation control unit 105 that maintains the activated state during the pass voltage rise interval. The second regulating unit 203 stabilizes the second path PATH2 using the pass voltage VPASS generated by the pass voltage generation unit 201 in response to generation of the third control signal EN3 by the operation control unit 105 that maintains the activated state during the pass voltage keeping interval.

In this example, to "stabilizing" the second path PATH2 includes the second regulating unit 203 maintaining the voltage level of the second path PATH2 at the level of the pass voltage VPASS by adjusting the voltage level of the second path PATH2 when the voltage level of the second path PATH2 is different from the level of the pass voltage VPASS. For example, when the voltage level of the second path PATH2 is lower than the level of the pass voltage VPASS, the second regulating unit 203 raises the voltage level of the second path PATH2 to the level of the pass voltage VPASS and maintains the voltage level of the second path PATH2 at the level of the pass voltage VPASS.

According to an embodiment, the first regulating unit 202 and the second regulating unit 203 stabilizes the first path PATH1 and the second path PATH2 using a feedback control method.

According to an embodiment, the first regulating unit 202 and the second regulating unit 203 stabilize the first path PATH1 and the second path PATH2, respectively, using a low dropout (LDO) regulator method.

The first regulating unit 202 and the second regulating unit 203 may each include a plurality of regulators.

When entering an equalizing interval and generating the equalizing voltage VEQ within the first regulating unit 202, the first regulating unit 202 identifies whether the equalizing interval is an initial equalizing interval entered by the first regulating unit 202 before a pass voltage rise interval or a post equalizing interval that the first regulating unit 202 enters after a pass voltage keeping interval and determines the level of the equalizing voltage VEQ generated within the first regulating unit 202 based on a result of the identifying. The first regulating unit 202 stabilizes the first path PATH1 at the level of the equalizing voltage VEQ that is generated at the level of the ground voltage during the initial equalizing interval that the first regulating unit 202 enters before the pass voltage rise interval in response to the first control signal EN1 and the second control signal EN2. The first regulating unit 202 stabilizes the first path PATH1 at the level of the equalizing voltage VEQ that is generated at a level higher than the level of the ground voltage VSS and lower than the level of the source voltage VDD during the post equalizing interval entered by the first regulating unit 202 after the pass voltage keeping interval in response to the first control signal EN1 and the second control signal EN2.

For example, in response to the second control signal EN2 changing from the deactivated state to the activated state when the first control signal EN1 was not activated after initialization of the first regulating unit 202, the first regulating unit 202 identifies an equalizing interval as an initial equalizing interval entered by the first regulating unit 202 before a pass voltage rise interval. When the equalizing interval entered by the first regulating unit 202 is the initial equalizing interval, the first regulating unit 202 generates the equalizing voltage VEQ at the level of the ground voltage VSS.

For example, in response to the second control signal EN2 changing from the deactivated state to the activated state when the first control signal EN1 is activated at least once after the initialization of the first regulating unit 202, the first regulating unit 202 identifies an equalizing interval as a post equalizing interval after a pass voltage keeping interval. When the equalizing interval entered by the first regulating unit 202 is the post equalizing interval, the first regulating unit 202 generates the equalizing voltage VEQ at a level higher than the level of the ground voltage VSS and lower than the level of the source voltage VDD. The first regulating unit 202 is initialized in response to the first regulating unit 202 exiting the post equalizing interval.

For example, a separate control signal (not shown) is generated by the operation control unit 105. The operation control unit 105 generates the separate control signal that distinguishes between an initial equalizing interval and a post equalizing interval, for example, a control signal different from the control signals EN1, EN2, and EN3. The operation control unit 105 transmits the separate control signal to the first regulating unit 202 such that the first regulating unit 202 adjusts the level of the equalizing voltage VEQ.

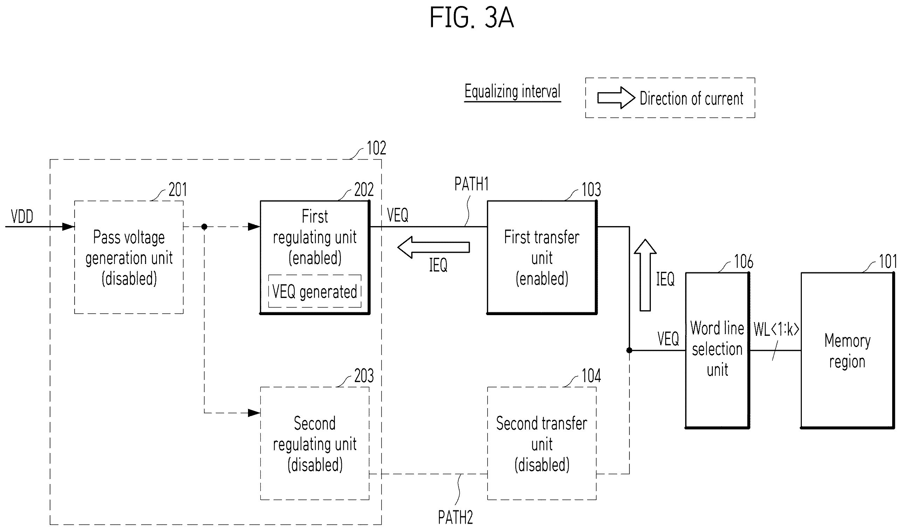

FIG. 3A to FIG. 3C illustrate an example of an operation including transferring the pass voltage and the equalizing voltage in the memory device, for example, as illustrated FIG. 1 and FIG. 2.

FIG. 3A to FIG. 3C illustrate a memory device during transfer of the pass voltage VPASS and the equalizing voltage VEQ, for example, when the memory device as described with reference to FIG. 1 and FIG. 2 performs a program operation or a read operation.

Referring to FIG. 3A, during an equalizing interval included in the program operation or the read operation, the pass voltage generation unit 201 does not generate the pass voltage VPASS. The first regulating unit 202 generates the equalizing voltage VEQ and transmits the equalizing voltage VEQ to the plurality of word lines WL<1:k> included in the memory region 101 through the first path PATH1 and the word line selection unit 106.

For example, the pass voltage generation unit 201 is disabled because the pass voltage VPASS is not used during the equalizing interval included in the program operation or the read operation. During the equalizing interval, the pass voltage generation unit 201 does not generate the pass voltage VPASS.

In an embodiment, the second path PATH2 that transfers only the pass voltage VPASS is not used because the pass voltage generation unit 201 does not generate the pass voltage VPASS. Accordingly, the second regulating unit 203 and the second transfer unit 104 are disabled.

During the equalizing interval, an operation including equalizing the voltage levels of the plurality of word lines WL<1:k> included in the memory region 101 to the level of the equalizing voltage VEQ is performed. The first regulating unit 202 is enabled to generate the equalizing voltage VEQ. When identifying that the equalizing interval is an initial equalizing interval entered by the first regulating unit 202 before a pass voltage rise interval, the first regulating unit 202generates the equalizing voltage VEQ at the level of the ground voltage VSS. When identifying that the equalizing interval is a post equalizing interval entered by the first regulating unit 202 after a pass voltage keeping interval, the first regulating unit 202 generates the equalizing voltage VEQ at a level higher than the level of the ground voltage VSS and lower than the level of the source voltage VDD.

The equalizing voltage VEQ that is generated by the first regulating unit 202 is transmitted to the plurality of word lines WL<1:k> included in the memory region 101 through the first path PATH1 and the word line selection unit 106 according to an operation of the first transfer unit 103 that is enabled during the equalizing interval.

When the equalizing interval is the initial equalizing interval entered by the first regulating unit 202 before the pass voltage rise interval, the first regulating unit 202 equalizes the voltage levels of the plurality of word lines WL<1:k> selected by the word line selection unit 106 at the level of the ground voltage VSS because the equalizing voltage VEQ is in the state in which the equalizing voltage VEQ is at the level of the ground voltage VSS. In this example, to equalize the voltage levels of the plurality of word lines WL<1:k> at the level of the ground voltage VSS includes decreasing or lowering the voltage levels of the plurality of word lines WL<1:k>. Accordingly, a current IEQ flows from the plurality of word lines WL<1:k> and flows to the first regulating unit 202 through the word line selection unit 106, the first transfer unit 103, and the first path PATH1 in this example.

When the equalizing interval is the post equalizing interval entered by the first regulating unit 202 after the pass voltage keeping interval, the first regulating unit 202 equalizes the voltage levels of the plurality of word lines WL<1:k> selected by the word line selection unit 106 at a level higher than the level of the ground voltage VSS and lower than the level of the source voltage VDD because the equalizing voltage VEQ is in a state in which the equalizing voltage VEQ is at as a level higher than the level of the ground voltage VSS and lower than the level of the source voltage VDD. In this example, to equalize the voltage levels of the plurality of word lines WL<1:k> at a level higher than the level of the ground voltage VSS and lower than the level of the source voltage VDD during the post equalizing interval includes the voltage levels of the plurality of word lines WL<1:k> are lowered because an unselected word line, among the plurality of word lines WL<1:k>, is in a state in which the unselected word line is at the level of the pass voltage VPASS and a selected word line, among the plurality of word lines WL<1:k>, is in a state in which the selected word line is at the level of a program or read voltage during the pass voltage keeping interval entered by the first regulating unit 202 from which the first regulating unit 202 exits before the post equalizing interval. Accordingly, the current IEQ flows from the plurality of word lines WL<1:k> and flows to the first regulating unit 202 through the word line selection unit 106, the first transfer unit 103, and the first path PATH 1.

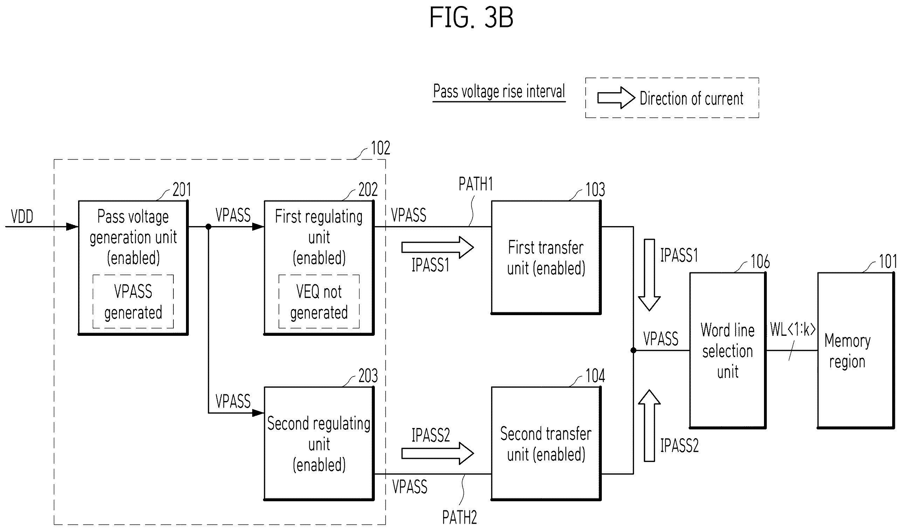

Referring to FIG. 3B, during a pass voltage rise interval included in the program operation or the read operation, the pass voltage generation unit 201 generates the pass voltage VPASS. During the pass voltage rise interval included in the program operation or the read operation, the first regulating unit 202 transfers the pass voltage VPASS generated by the pass voltage generation unit 201 to the first path PATH1 and the word line selection unit 106. During the pass voltage rise interval included in the program operation or the read operation, the second regulating unit 203 transfers the pass voltage VPASS generated by the pass voltage generation unit 201 and the word line selection unit 106 via the second path PATH2.

For example, the pass voltage generation unit 201 is enabled because the pass voltage VPASS is used during the pass voltage rise interval included in the program operation or the read operation. During the pass voltage rise interval, the pass voltage generation unit 201 generates the pass voltage VPASS.

During the pass voltage rise interval included in the read operation, the first regulating unit 202 transfers the pass voltage VPASS to an unselected word line, among the plurality of word lines WL<1:k> included in the memory region 101, through the first path PATH1 and the second path PATH2. During the pass voltage rise interval included in the program operation, the first regulating unit 202 transfers the pass voltage VPASS to the plurality of word lines WL<1:k> included in the memory region 101 through the first path PATH1 and the second path PATH2. The first regulating unit 202, the first transfer unit 103, the second regulating unit 203, and the second transfer unit 104 are enabled.

For example, the first regulating unit 202 that is enabled during the pass voltage rise interval does not generate the equalizing voltage VEQ. The first regulating unit 202 that is enabled during the pass voltage rise interval stabilizes the first path PATH1 using the pass voltage VPASS generated by the pass voltage generation unit 201. The first transfer unit 103 that is enabled during the pass voltage rise interval transfers the pass voltage VPASS by connecting the first path PATH1 stabilized at the level of the pass voltage VPASS by the first regulating unit 202 to the word line selection unit 106. The word line selection unit 106 transfers the pass voltage VPASS to each of the plurality of word lines WL<1:k> after the start of the program operation and transfers the pass voltage VPASS to an unselected word line, among the plurality of word lines WL<1:k>, after the start of the read operation.

The second regulating unit 203 that is enabled during the pass voltage rise interval stabilizes the second path PATH2 using the pass voltage VPASS generated by the pass voltage generation unit 201. The second transfer unit 104 that is enabled during the pass voltage rise interval transfers the pass voltage VPASS by connecting the second path PATH2 stabilized at the level of the pass voltage VPASS by the second regulating unit 203 to the word line selection unit 106. The word line selection unit 106 transfers the pass voltage VPASS to each of the plurality of word lines WL<1:k> after the start of the program operation and transfers the pass voltage VPASS to an unselected word line, among the plurality of word lines WL<1:k>, after the start of the read operation.

During the pass voltage rise interval, the pass voltage VPASS is transmitted from the pass voltage generation unit 201 to the word line selection unit 106 via the first path PATH1 and the second path PATH2.

During an initial equalizing interval entered by the first regulating unit 202 from which the first regulating unit 202 exits before entering the pass voltage rise interval, the memory device is in a state in which the voltage levels at the plurality of word lines WL<1:k> are equalized using the equalizing voltage VEQ at the level of the ground voltage VSS. An operation including applying the pass voltage VPASS to the plurality of word lines WL<1:k> during the pass voltage rise interval is an operation including raising the voltage levels of the plurality of word lines WL<1:k>. Currents IPASS1 and IPASS2 flow from the first regulating unit 202 and the second regulating unit 203, respectively, and flow to the plurality of word lines WL<1:k> through the word line selection unit 106 via the first transfer unit 103 and the first path PATH1, and the second transfer unit 104 and the second path PATH2, respectively.

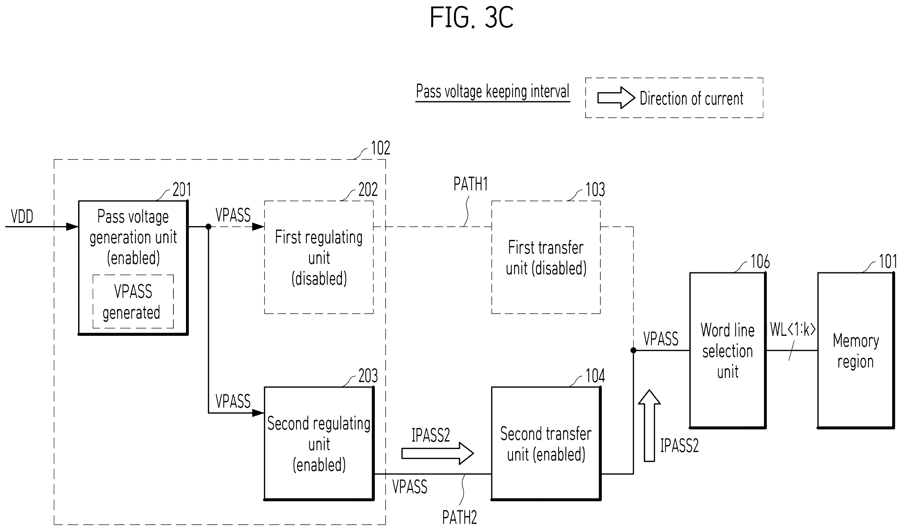

Referring to FIG. 3C, during a pass voltage keeping interval included in the program operation or the read operation, the pass voltage generation unit 201 generates the pass voltage VPASS. The second regulating unit 203 transfers the pass voltage VPASS generated by the pass voltage generation unit 201 to the word line selection unit 106 via the second path PATH2. The first regulating unit 202 and the first transfer unit 103 are disabled, thus the pass voltage VPASS is not transmitted via the first path PATH1.

For example, during a pass voltage rise interval included in the program operation or the read operation, the pass voltage generation unit 201 is enabled to generate the pass voltage VPASS. During the pass voltage rise interval, the pass voltage generation unit 201 generates the pass voltage VPASS.

During the pass voltage keeping interval included in the program operation or the read operation, the pass voltage VPASS is transferred to an unselected word line, among the plurality of word lines WL<1:k> included in the memory region 101, through the second path PATH2 without using the first path PATH1. The first regulating unit 202 and the first transfer unit 103 are disabled, and the second regulating unit 203 and the second transfer unit 104 are enabled. The pass voltage keeping interval is an interval entered by the second regulating unit 203 after the pass voltage rise interval. The unselected word line, among the plurality of word lines WL<1:k> included in the memory region 101, can be stably maintained at the level of the pass voltage VPASS during the pass voltage keeping interval although the second path PATH2 is used because the unselected word line, among the plurality of word lines WL<1:k>, is in a state in which the unselected word line is driven to the level of the pass voltage VPASS at a time at which the pass voltage keeping interval is entered. The first regulating unit 202 and the first transfer unit 103 are disabled because the first path PATH1 is not used during the pass voltage keeping interval in an embodiment.

For example, the second regulating unit 203 that is enabled during the pass voltage keeping interval stabilizes the second path PATH2 using the pass voltage VPASS generated by the pass voltage generation unit 201. The second transfer unit 104 that is enabled during the pass voltage keeping interval transfers the pass voltage VPASS to the unselected word line, among the plurality of word lines WL<1:k>, that is selected by the word line selection unit 106 by connecting the second path PATH2, stabilized at the level of the pass voltage VPASS by the second regulating unit 203, to the word line selection unit 106.

During the pass voltage keeping interval, the pass voltage VPASS is transferred from the pass voltage generation unit 201 to the word line selection unit 106 via the second path PATH2 in this example.

During the pass voltage rise interval entered by the second regulating unit 203 from which the second regulating unit 203 exits before entering the pass voltage keeping interval, the unselected word line is in a state in which the unselected word line is driven to the level of the pass voltage VPASS. Although the unselected word line selected by the word line selection unit 106 is in the state in which the unselected word line is driven to the level of the pass voltage VPASS during the pass voltage rise interval, a current IPASS2 flows from the second regulating unit 203 and flows to the unselected word line through the second transfer unit 104 and the second path PATH2 such that the unselected word line is stably maintained at the level of the pass voltage VPASS during the pass voltage keeping interval.

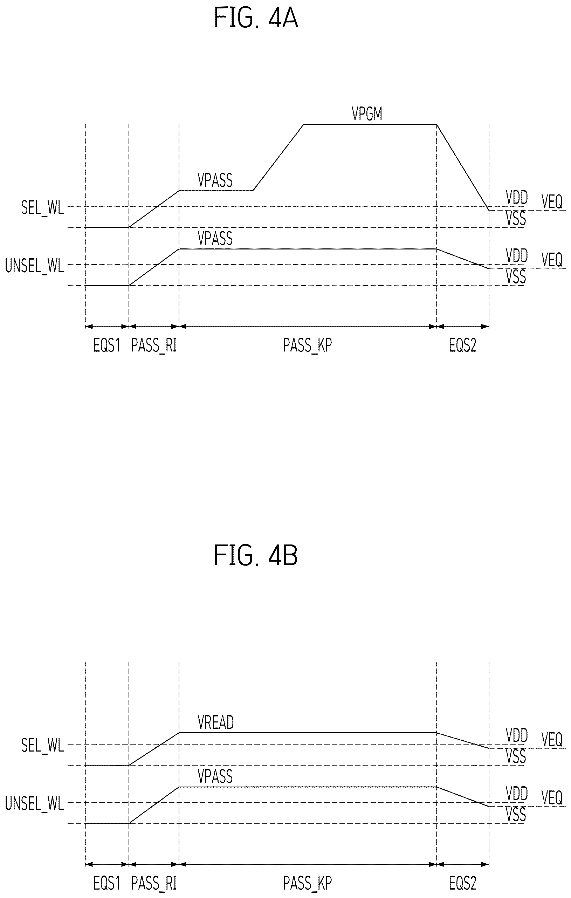

FIG. 4A and FIG. 4B are timing diagrams during change of the voltage levels of a plurality of word lines, for example, after the start of program operations and read operations of the memory device, for example, as described with reference to FIG. 1 and FIG. 2.

FIG. 4A and FIG. 4B are examples of timing diagrams during change of the voltage levels of each of a selected word line SEL_WL and an unselected word line UNSEL_WL, among the plurality of word lines WL<1:k>, when the memory device, such as described with reference to FIG. 1 and FIG. 2, performs program operations and read operations.

FIG. 4A illustrates change of the voltage level of each of the selected word line SEL_WL and the unselected word line UNSEL_WL, among the plurality of word lines WL<1:k>, when the memory device performs a program operation.

For example, when the memory device starts the program operation, the memory device enters an initial equalizing interval EQS1 and equalize the voltage levels of each of the plurality of word lines WL<1:k> at the level of the equalizing voltage VEQ. In this example, during the initial equalizing interval, the memory device establishes the equalizing voltage VEQ at the level of the ground voltage VSS. Accordingly, during the initial equalizing interval, each of the plurality of word lines WL<1:k> is equalized at the level of the ground voltage VSS.

The memory device enters a pass voltage rise interval PASS_RI after the initial equalizing interval EQS1. During the pass voltage rise interval PASS_RI included in the program operation, the voltage levels of each of the plurality of word lines WL<1:k> is raised or increased to the level of the pass voltage VPASS. The memory device, according to an embodiment, transfers the pass voltage VPASS through each path physically present from the voltage generation unit 102 to the word line selection unit 106, the first path PATH1 and the second path PATH2. Accordingly, during the pass voltage rise interval PASS_RI included in the program operation of the memory device according to an embodiment, the speed at which the voltage levels of the plurality of word lines WL<1:k> rises from the level of the ground voltage VSS to the level of the pass voltage VPASS may be faster than in a case where the pass voltage VPASS is transferred through only one of the paths, such as the second path PATH2.

The memory device enters a pass voltage keeping interval PASS_KP after the pass voltage rise interval PASS_RI. During the pass voltage keeping interval PASS_KP included in the program operation, the memory device continuously maintains the unselected word line UNSEL_WL, among the plurality of word lines WL<1:k>, at the level of the pass voltage VPASS. The memory device, according to an embodiment, transfers the pass voltage VPASS via at least one of the physical paths from the voltage generation unit 102 to the word line selection unit 106, such as through the second path PATH2 during the pass voltage keeping interval PASS_KP. Accordingly, during the pass voltage keeping interval PASS_KP included in the program operation of the memory device according to an embodiment, components that are not utilized while the unselected word line UNSEL_WL, among the plurality of word lines WL<1:k>, is maintained at the level of the pass voltage VPASS, the first regulating unit 202 and the first transfer unit 103 are disabled.

During the pass voltage keeping interval PASS_KP included in the program operation, the voltage level of the selected word line SEL_WL, among the plurality of word lines WL<1:k>, rises from the level of the pass voltage VPASS to the level of a program voltage VPGM. Accordingly, the voltage level of the threshold voltage of a memory cell connected to the selected word line SEL_WL is changed. In this example, an operation including applying the program voltage VPGM to the selected word line SEL_WL is known in the industry.

The memory cell enter a post equalizing interval EQS2 after the pass voltage keeping interval PASS_KP and equalizes the voltage levels of each of the plurality of word lines WL<1:k> at the level of the equalizing voltage VEQ. In this example, during the post equalizing interval, the equalizing voltage VEQ is at a voltage level higher than the level of the ground voltage VSS and lower than the level of the source voltage VDD. Accordingly, during the post equalizing interval, the voltage levels of each of the plurality of word lines WL<1:k> is equalized at a voltage level higher than the level of the ground voltage VSS and lower than the level of the source voltage VDD.

FIG. 4B illustrates change of the voltage level of each of a selected word line SEL_WL and an unselected word line UNSEL_WL, among the plurality of word lines WL<1:k>, when the memory device performs a read operation.

For example, when starting the read operation, the memory device enters an initial equalizing interval EQS1 and equalizes the voltage levels of each of the plurality of word lines WL<1:k> at the level of the equalizing voltage VEQ. In this example, during the initial equalizing interval EQS1, the equalizing voltage VEQ is at the level of the ground voltage VSS. Accordingly, during the initial equalizing interval EQS1, the voltage levels of each of the plurality of word lines WL<1:k> are equalized at the level of the ground voltage VSS.

The memory device enters a pass voltage rise interval PASS_RI after the initial equalizing interval EQS1. During the pass voltage rise interval PASS_RI included in the read operation, the voltage levels of each of the unselected word lines UNSEL_WL, among the plurality of word lines WL<1:k>, are raised to the level of the pass voltage VPASS. The memory device according to an embodiment transfers the pass voltage VPASS through each of the physical paths from the voltage generation unit 102 to the word line selection unit 106, the first path PATH1 and the second path PATH2. Accordingly, during the pass voltage rise interval PASS_RI included in the read operation of the memory device according to an embodiment, the speed at which the voltage levels of the unselected word lines UNSEL_WL, among the plurality of word lines WL<1:k>, rises from the level of the ground voltage VSS to the level of the pass voltage VPASS may be faster than in a case where the pass voltage VPASS is transferred through only one of the paths, such as the second path PATH2.

The memory device enters a pass voltage keeping interval PASS_KP after the pass voltage rise interval PASS_RI. During the pass voltage keeping interval PASS_KP included in the read operation, the voltage level at the unselected word line UNSEL_WL, among the plurality of word lines WL<1:k> is continuously maintained at the level of the pass voltage VPASS. In this example, the memory device according to an embodiment transfers the pass voltage VPASS through at least one of the physical paths from the voltage generation unit 102 to the word line selection unit 106, for example, through the second path PATH2 during the pass voltage keeping interval PASS_KP. Accordingly, during the pass voltage keeping interval PASS_KP included in the read operation of the memory device according to an embodiment, a component that not utilized while the unselected word line UNSEL_WL, among the plurality of word lines WL<1:k>, is maintained at the level of the pass voltage VPASS, for example, the first regulating unit 202 and the first transfer unit 103, may be disabled.

During the pass voltage rise interval PASS_RI and the pass voltage keeping interval PASS_KP included in the read operation, a read voltage VREAD is applied to the selected word line SEL_WL, among the plurality of word lines WL<1:k>. Accordingly, the level of the threshold voltage of a memory cell that is connected to the selected word line SEL_WL is sensed. In this example, an operation including applying the read voltage VREAD to the selected word line SEL_WL is known in the industry.

After the pass voltage keeping interval PASS_KP, the memory device enters a post equalizing interval EQS2 and equalizes the voltage level of each of the plurality of word lines WL<1:k> at the level of the equalizing voltage VEQ. During the post equalizing interval EQS2, the equalizing voltage VEQ is at a level higher than the level of the ground voltage VSS and lower than the level of the source voltage VDD. Accordingly, during the post equalizing interval EQS2, the voltage level of each of the plurality of word lines WL<1:k> is equalized at a voltage level that is higher than the level of the ground voltage VSS and lower than the level of the source voltage VDD.

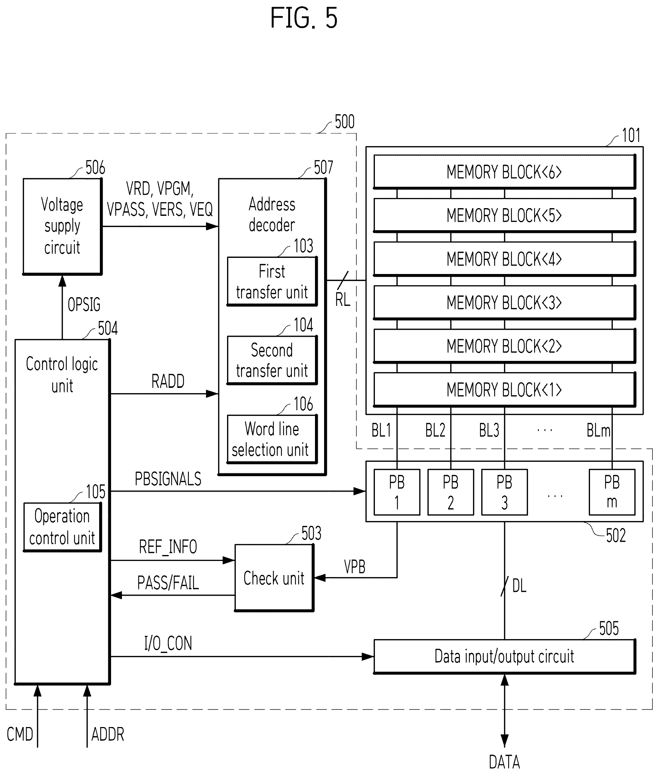

FIG. 5 illustrates a memory device according to an embodiment of the present disclosure.

Referring to FIG. 5, the memory device includes the memory cell array 101 and the control circuit 500. The control circuit 500 includes a control logic unit 105, a page buffer unit 502, a check unit 503, a data input/output circuit 505, a voltage supply circuit 506, and an address decoder 507. The address decoder 507 includes the first transfer unit 103, the second transfer unit 104, and the word line selection unit 106 described with reference to FIG. 1. The voltage supply circuit 506 includes the voltage generation unit 102 described with reference to FIG. 1. The control logic unit 504 includes the operation control unit 105 described with reference to FIG. 1. Although not illustrated in FIG. 5, the first path PATH1 and the second path PATH2 are located between the voltage supply circuit 506 and the address decoder 507.

The memory cell array 101 includes a plurality of memory blocks MEMORY BLOCK<1:6>. The plurality of memory blocks MEMORY BLOCK<1:6> are connected to an address decoder 507 via a row line RL. The plurality of memory blocks MEMORY BLOCK<1:6> is connected to the page buffer unit 502 using bit lines BL1 to BLm. Each of the memory blocks MEMORY BLOCK<1:6> includes a plurality of memory cells.

The control circuit 500 is configured to perform a program operation, a read operation, or an erase operation on a selected region of the memory cell array 101. The control circuit 500 controls the memory cell array 101. For example, the control circuit 500 applies various operating voltages to the row line RL and the bit lines BL1 to BLm and discharges the applied voltages.

The address decoder 507 of the control circuit 500 is connected to the memory cell array 101 via the row line RL. The row line RL may include a drain selection line, the word lines, a source selection line, and a common source line.

The address decoder 507 is configured to operate in response to control by the control logic unit 504. The address decoder 507 receives an address RADD from the control logic unit 504.

The address decoder 507 is configured to decode a block address of the received address RADD. The address decoder 507 selects at least one memory block among the memory blocks MEMORY BLOCK<1:6> according to the decoded block address. The address decoder 507 is configured to decode a row address of the received address RADD. The address decoder 507 selects at least one word line among word lines of the selected memory block according to the decoded row address. The word line selection unit 106 included in the address decoder 507 selects one of the plurality of word lines WL<1:k> included in a selected memory block as a selected word line, which word line is a target for a program operation or a read operation, and selects the word lines, except for the selected word line, as unselected word lines. The first transfer unit 103 included in the address decoder 507 transfers the pass voltage VPASS or the equalizing voltage VEQ received from the voltage generation unit 102 included in the voltage supply circuit 506 to the word line selection unit 106 through the first path PATH1. The second transfer unit 104 included in the address decoder 507 transfers the pass voltage VPASS received from the voltage generation unit 102 included in the voltage supply circuit 506 to the word line selection unit 106 through the second path PATH2.

The voltage supply circuit 506 of the control circuit 500 is configured to generate a plurality of operating voltages VRD, VPGM, VPASS, VERS, VEQ using an external power supply voltage. The voltage supply circuit 506 operates in response to control by the control logic unit 504.

In an embodiment, the voltage supply circuit 506 regulates the external power supply voltage and generates an internal power supply voltage.

In an embodiment, the voltage supply circuit 506 generates the plurality of operating voltages VRD, VPGM, VPASS, VERS, VEQ using the external power supply voltage or the internal power supply voltage. For example, the voltage supply circuit 506 generates a plurality of erase voltages VERS, a plurality of program voltages VPGM, a plurality of pass voltages VPASS, a plurality of selective read voltages, and a plurality of unselective read voltages.

The generated operating voltages VRD, VPGM, VPASS, VERS, VEQ are supplied to the memory cell array 101 by the address decoder 507.

The page buffer unit 502 includes a plurality of page buffers PB1 to PBm. The plurality of page buffers PB1 to PBm are connected to the memory cell array 101 via the plurality of bit lines BL1 to BLm, respectively. The plurality of page buffers PB1 to PBm operate in response to control by the control logic unit 504.

The plurality of page buffers PB1 to PBm communicates data DATA with the data input/output circuit 505. During the program operation, the plurality of page buffers PB1 to PBm receives the data DATA to be stored via the data input/output circuit 505 and a data line DL.

The data input/output circuit 505 includes a plurality of input/output buffers (not illustrated) that receive the data DATA. During the program operation, the data input/output circuit 505 receives the data DATA to be stored from an external device. The data input/output circuit 505 outputs the data DATA that is transmitted from the plurality of page buffers PB1 to PBm included in the page buffer unit 502 to the external device during the read operation.

The control logic unit 504 is connected to the address decoder 507, the voltage supply circuit 506, the page buffer unit 502, the data input/output circuit 505, and the check unit 503 included in the control circuit 500. The control logic unit 504 is configured to control overall operation of the memory device. The control logic unit 504 operates in response to a command CMD from the external device.

The control logic unit 504 controls the control circuit 500 by generating various signals in response to the command CMD and an address ADDR. For example, the control logic unit 504 generates an operation signal OPSIG, an address RADD, a read and write control signal PBSIGNALS, and the reference information REF_INFO in response to the command CMD and the address ADDR. The control logic unit 504 outputs the operation signal OPSIG to the voltage supply circuit 506, outputs the address RADD to the address decoder 507, outputs the read and write control signal PBSIGNALS to the page buffer unit 502, and outputs the reference information REF_INFO to the check unit 503. The control logic unit 504 determines whether a verification operation passed or failed in response to the pass or fail signal PASS/FAIL output by the check unit 503.

Concepts are disclosed in conjunction with examples and embodiments. Those skilled in the art will understand that various modifications, additions, combinations, and substitutions are possible without departing from the scope and technical concepts of the present disclosure. The embodiments disclosed in the present specification should be considered from an illustrative standpoint and not a restrictive standpoint. Therefore, the scope of the present disclosure is not limited to these descriptions. All changes within the meaning and range of equivalency of the claims are included within their scope.

## Claims

1. A memory device comprising:
a memory region comprising a plurality of memory cells connected to a plurality of word lines and a plurality of bit lines;
a voltage generation unit configured to generate a pass voltage and an equalizing voltage;
a first transfer unit configured to transfer the pass voltage or the equalizing voltage between the voltage generation unit and the plurality of word lines via a first path;
a second transfer unit configured to transfer the pass voltage between the voltage generation unit and the plurality of word lines via a second path physically separated from the first path; and
an operation control unit configured to enable the first transfer unit and the second transfer unit such that the pass voltage is transferred through the first path and the second path during a pass voltage rise interval and to enable the first transfer unit such that the equalizing voltage is transferred via the first path during an equalizing interval after a start of a read operation or a program operation.

2. The memory device of claim 1, wherein the operation control unit enables the second transfer unit such that the second transfer unit transfers the pass voltage through the second path during a pass voltage keeping interval entered by the second transfer unit after the pass voltage rise interval.

3. The memory device of claim 2, wherein:
the operation control unit generates a first control signal that is activated during the pass voltage rise interval and deactivated during the pass voltage keeping interval and the equalizing interval, generates a second control signal that is activated during the equalizing interval and deactivated during the pass voltage rise interval and the pass voltage keeping interval, and generates a third control signal that is activated during the pass voltage keeping interval and deactivated during the pass voltage rise interval and the equalizing interval;
the first transfer unit is enabled during an activated interval of the first control signal and the second control signal; and
the second transfer unit is enabled during an activated interval of the first control signal and the third control signal.

4. The memory device of claim 2, further comprising a word line selection unit configured to connect unselected word lines that are not selected as read operation or program operation targets, among the plurality of word lines, to the first transfer unit and the second transfer unit during an activated interval of the first control signal and the third control signal and to connect the plurality of word lines to the first transfer unit and the second transfer unit during an activated interval of the second control signal.

5. The memory device of claim 3, wherein the voltage generation unit comprises:
a pass voltage generation unit configured to generate the pass voltage by charge pumping a source voltage during the activated interval of the first control signal and the third control signal;
a first regulating unit configured to stabilize the first path at a voltage level of the equalizing voltage during the activated interval of the second control signal and configured to stabilize the first path at a voltage level of the pass voltage generated by the pass voltage generation unit during the activated interval of the first control signal; and
a second regulating unit configured to stabilize the second path at the level of the pass voltage generated by the pass voltage generation unit during the activated interval of the first control signal and the third control signal.

6. The memory device of claim 5, wherein the first regulating unit stabilizes the first path at the level of the equalizing voltage generated at a level of a ground voltage during the equalizing interval entered by the first regulating unit before the pass voltage rise interval in response to the first control signal and the second control signal.

7. The memory device of claim 5, wherein the first regulating unit stabilizes the first path at the voltage level of the equalizing voltage generated at a voltage level higher than the level of the ground voltage and lower than the voltage level of the source voltage during the equalizing interval entered by the first regulating unit after the pass voltage keeping interval in response to the first control signal and the second control signal.

8. A method of operating a memory device comprising a memory region comprising a plurality of memory cells connected to a plurality of word lines and a plurality of bit lines, a voltage generation unit configured to generate a pass voltage and an equalizing voltage, and a first path physically separated from a second path between the voltage generation unit and the plurality of word lines, the method comprising:
a first transfer process including transferring the pass voltage generated by the voltage generation unit to at least one word line, among the plurality of word lines, via the first path and the second path during a pass voltage rise interval after a start of a read operation or a program operation; and
a second transfer process including transferring the equalizing voltage generated by the voltage generation unit to the plurality of word lines via the first path during an equalizing interval after the start of the read operation or the program operation.

9. The method of claim 8, further comprising a third transfer process including transferring the pass voltage to the at least one word line through the second path during a pass voltage keeping interval entered after the pass voltage rise interval after the start of the read operation or the program operation.

10. The method of claim 9, wherein during the first transfer process and the third transfer process, the at least one word line includes unselected word lines not selected, among the plurality of word lines, as a read operation target or a program operation target.

11. The method of claim 9, further comprising:
generating the pass voltage using a charge pumping method through the voltage generation unit during the pass voltage rise interval and the pass voltage keeping interval;
stabilizing the first path and the second path using the pass voltage generated during the pass voltage rise interval; and
stabilizing the second path using the pass voltage generated during the pass voltage keeping interval.

12. The method of claim 11, further comprising stabilizing the first path using the equalizing voltage generated at a voltage level of a ground voltage by the voltage generation unit during the equalizing interval when the equalizing interval is entered before the pass voltage rise interval.

13. The method of claim 11, further comprising stabilizing the first path using the equalizing voltage generated at a voltage level higher than a level of a ground voltage and lower than a voltage level of a source voltage by the voltage generation unit during the equalizing interval when the equalizing interval is entered after the pass voltage keeping interval.

14. A method comprising:
generating, by a voltage generation unit, a pass voltage and an equalizing voltage in a memory device comprising a plurality of memory cells connected to a plurality of word lines;
transferring the pass voltage to at least one word line, among the plurality of word lines, via a first path and a second path, which are physically separated from each other, during a pass voltage rise interval after a start of a read operation or a program operation; and
transferring the equalizing voltage to the plurality of word lines via the first path during an equalizing interval after the start of the read operation or the program operation.
